# EUROPEAN PATENT APPLICATION

(11) **EP 4 568 447 A1**
(43) Date of publication of application: **11.06.2025**
(21) Application number: 24213479.9
(22) Date of filing: 18.11.2024
(51) Int. Cl.: H10D 30/01, H10D 30/66, H10D 62/10, H10D 62/13, H10D 62/832

(54) **POWER SEMICONDUCTOR DEVICES AND POWER CONVERTER INCLUDING THE SAME**

(30) Priority: 06.12.2023 KR 20230175454; 07.08.2024 KR 20240105727
(71) Applicant: LX Semicon Co., Ltd., Daejeon 34027 (KR)
(72) Inventor: LEE, Chung Kwang, Daejeon 34027 (KR); KIM, Jin Gon, Daejeon 34027 (KR)
(74) Representative: Goddar, Heinz J.

(57) **Abstract**

A power semiconductor device according to an embodiment and a power converter including the same may include: a substrate; an epi layer of a first conductivity type disposed on the substrate; a plurality of wells of the second conductivity types disposed spaced apart from each other on the epi layer ; and a gate disposed between the wells and a gate insulating layer disposed to surround the gate; and a doped region of the first conductivity type disposed on a side of the gate insulating layer.

The doped region may include a first doped region of the first conductivity type having a first horizontal width and a second doped region of the first conductivity type disposed below the first doped region and having a second horizontal width smaller than the first horizontal width.

## Description

### TECHNICAL FIELD

The embodiment relates to a power semiconductor device and a power converter including the same.

### BACKGROUND

Power semiconductors are one of the key elements that determine the efficiency, speed, durability, and reliability of power electronics systems.

Recently, with the development of the power electronics industry, research is actively being conducted on WBG (Wide Bandgap) power semiconductors such as silicon carbide (SiC) and gallium nitride (GaN) to replace silicon (Si) power semiconductors that were previously used, which are reaching their physical limits.

WBG power semiconductor devices have a band gap energy approximately three times that of Si power semiconductor devices, which results in low intrinsic carrier concentration, high dielectric breakdown field (approximately 4 to 20 times), high thermal conductivity (approximately 3 to 13 times), and large electron saturation velocity (approximately 2 to 2.5 times).

Due to these characteristics, the WBG power semiconductor devices can operate in high temperature and high voltage environments, and have high switching speeds and low switching losses. Among them, gallium nitride (GaN) power semiconductor devices can be used in low voltage systems, and silicon carbide (SiC) power semiconductor devices can be suitable for high voltage systems.

Conventional SiC MOSFETs can be classified into trench structure MOSFETs, vertical doubly implanted structure MOSFETs (DIMOSFETs), and lateral diffused structure MOSFETs depending on their structures. DIMOSFET is also called Planar MOSFET or VDMOSFET.

On the other hand, MOSFET with trench structure has a problem in that electric field is concentrated in the edge area according to a shape of the trench gate. Even if P-shield process is performed to solve this, there are problems such as additional mask layers, increased process difficulty, and increased cell pitch, so a new solution is needed.

In addition, conventional MOSFET with trench structure has a problem in that the reliability of the device is reduced because it is difficult to precisely control the channel area and short circuit characteristics.

### SUMMARY

One of the technical objects of the embodiment is to prevent electric field concentration in the lower edge area of the trench gate.

In addition, one of the technical objects of the embodiment is to control the length of the channel.

In addition, one of the technical objects of the embodiment is to prevent damage that occurs while forming the doping region.

In addition, one of the technical objects of the embodiment is to improve the reliability of the device during high-speed switching.

The technical objects of the embodiment are not limited to those described in this item and include those that can be understood through the description of the invention.

The technical solutions for achieving the technical objects of the embodiment are as follows. The power semiconductor device according to the embodiment and the power converter including the same may include a substrate (110); an epi layer of a first conductivity type (117) disposed on the substrate (110); a plurality of wells of a second conductivity type (130) disposed spaced apart from each other on the epi layer (117); a gate

(160) disposed between the plurality of wells (130) and a gate insulating layer (155) disposed to surround at least a portion of the gate (160); and may include a doped region of the first conductivity type (140) disposed on a side of the gate insulating layer (155).

In addition, in the embodiment, a lower surface of the doped region (140) may be positioned higher than a lower surface of the gate (160).

In addition, in the embodiment, a lower edge region of the gate insulating layer (155) may be in contact with the plurality of wells (130).

In addition, in the embodiment, a lower surface of the plurality of wells (130) may be positioned lower than a lower surface of the gate insulating layer (155).

In addition, in the embodiment, the doped region (140) and the epi layer (117) do not contact each other, and the plurality of wells (130) may be positioned between the doped region (140) and the epi layer (117).

In addition, in the embodiment, the doped region (140) may include a first doped region of the first conductivity type (140a) in contact with the source electrode and a second doped region of the first conductivity type (140b) in contact with the side surface of the gate insulating layer (155).

In addition, in the embodiment, a doping concentration of the second doped region (140b) may be substantially the same as a doping concentration of the first doped region (140a).

The lower surface of the second doped region (140b) may be positioned higher than the lower surface of the gate (160).

In addition, in the embodiment, the second doped region (140b) may be formed by an epitaxial re-growth process.

In addition, in the embodiment, the second doped region (140b) may not vertically overlap with the source contact layer (145).

In addition, in the embodiment, a vertical thickness of the second doped region may be at least 1/2 of the vertical thickness of the gate (160).

In addition, in the embodiment, a JFET region (150) disposed on the lower surface of the gate insulating layer (155) can be further included, and the JFET region (150) may be in contact with the plurality of wells (130).

The doping concentration deviation in the second doped region (140b) may be controlled to within 10%.

The first length (L1) of the second doped region (140b) in contact with the gate insulating layer (155) may be longer than the second length (L2) of the plurality of wells (130) in contact with the gate insulating layer.

The region of the plurality of wells (130) in contact with the gate insulating layer (155) may be arranged below the second doped region (140b).

In addition, the power semiconductor device according to the embodiment may include a substrate, an epi layer of a first conductivity type (117) arranged on the substrate, a plurality of wells (130) spaced apart from each other on the epi layer (117), a gate arranged between the wells (130), and a gate insulating layer arranged to surround the gate.

In addition, the power semiconductor device according to the embodiment may include a doped region (140) arranged on a side of the gate insulating layer, and the doped region (140) may include a first doped region of the first conductivity type (140a) having a first horizontal width and a third doped region of the first conductivity type (140c) arranged below the first doped region (140a) and having a second horizontal width smaller than the first horizontal width.

The doping concentration of the third doped region (140c) may be lower than the doping concentration of the first doped region.

The lower surface of the third doped region (140c) may be positioned higher than the lower surface of the gate (160).

The region of the plurality of wells (130) in contact with the gate insulating layer (155) may be arranged below the third doped region (140c).

The lower edge region of the gate insulating layer (155) may be surrounded by the plurality of wells (130).

The bottom surface of the plurality of wells (130) may be positioned lower than the bottom surface of the gate insulating layer (155).

The third doped region (140c) may be formed by an epitaxial re-growth process, and the first doped region (140a) may be formed by ion implantation.

In addition, the second doped region may be arranged inside the first doped region.

In addition, the upper surface of the second doped region may be positioned at the same height as the upper surface of the first doped region.

In addition, a thickness of the second doped region may be greater than a thicknesses of the first doped region.

In addition, the power semiconductor device according to the embodiment may include a substrate, an epi layer of a first conductivity type disposed on the substrate, a plurality of wells of a second conductivity type spaced apart from each other on the epi layer, a gate disposed between the wells , a gate insulating layer disposed to surround at least a portion of the gate and a doped region disposed on a side of the gate insulating layer. The doped region may include a first doped region having a first horizontal width and a third doped region disposed inside the first doped region and having a second horizontal width smaller than the first horizontal width.

The doping concentration of the third doped region may be lower than the doping concentration of the first doped region.

The lower surface of the third doped region may be positioned higher than the lower surface of the gate.

The lower surface of the wells may be positioned lower than the lower surface of the gate insulating layer.

The upper surface of the third doped region is positioned at the same height as the upper surface of the first doped region, and the thickness of the third doped region may be greater than a vertical thicknesses of the first doped region.

The technical effects of the embodiment are as follows. The power semiconductor device according to the embodiment has a technical effect of preventing electric field concentration in the lower edge region of the trench gate.

For example, the embodiment can prevent electric field concentration in the lower edge region of the trench gate by positioning the wells to surround the lower edge region of the trench gate.

In addition, the embodiment has a technical effect capable of controlling the length of the channel. For example, since the embodiment forms the second doped region through an epitaxial re-growth process rather than an implant process, the doping concentration can be uniformly controlled compared to the ion implantation process. Accordingly, a depth of the doping region can be precisely controlled, so that the length of the channel can be precisely controlled.

For example, since the doping concentration deviation in the second doped region is uniformly controlled to within about 5 to 10%, there is a special technical effect capable of precisely controlling the length of the channel.

In addition, the embodiment has a technical effect capable of preventing damage that occurs while forming the doping region. For example, since the embodiment forms the second doped region through an epitaxial re-growth process rather than an implant process without a separate P-shield process, damage that may occur during the implant process can be prevented.

In addition, the embodiment has a technical effect that can improve the reliability of the device during high-speed switching.

For example, since the doping concentration of the second doped region arranged on the trench gate side is formed lower than the doping concentration of the first doped region, the saturation current decreases and the SCWT (Short Circuit Withstand Time) increases, so that the reliability of the device during high-speed switching can be improved.

The technical effects of the embodiment are not limited to those described in this item and include those that can be understood through the description of the invention.

### BRIEF DESCRIPTION OF THE DRAWINGS

FIG. 1 is an example diagram of a power converter (1000) according to an embodiment.
FIG. 2 is a cross-sectional view of a power semiconductor device (100) according to an embodiment.
FIG. 3 is a cross-sectional view of a power semiconductor device according to the first embodiment.
FIGS. 4A to 4G are manufacturing process diagrams of a power semiconductor device according to the first embodiment.
Fig. 5 is a cross-sectional view of a power semiconductor device according to the second embodiment.

### DETAILED DESCRIPTION

Hereinafter, the embodiments disclosed in this specification will be described in detail with reference to the attached drawings. The suffixes 'module' and 'part' for components used in the following description are given or used interchangeably in consideration of the ease of writing the specification, and do not have distinct meanings or roles in themselves. In addition, the attached drawings are intended to facilitate easy understanding of the embodiments disclosed in this specification, and the technical ideas disclosed in this specification are not limited by the attached drawings. In addition, when an element such as a layer, region, or substrate is mentioned as existing 'on' another element, this includes that it may be directly on the other element, or that other intermediate elements may exist between them.

In the specification or claims, the meaning of "an element A includes at least one of a, b, and/or c" may include ① when the element A includes the element a, ② when the element A includes the element b, ③ when the element A includes the element c, ④ when the element A includes the elements a and b, ⑤ when the element A includes the elements band c, ⑥ when the element A includes the elements a and c, and ⑦ when the element A includes all elements of a, b, and c.

The singular expression includes the plural expression as well as the singular expression unless the context clearly indicates otherwise. For example, the meaning of "element A includes one structure (a structure)" may include the meaning of "the element A includes one or more structures (one or more structures)."

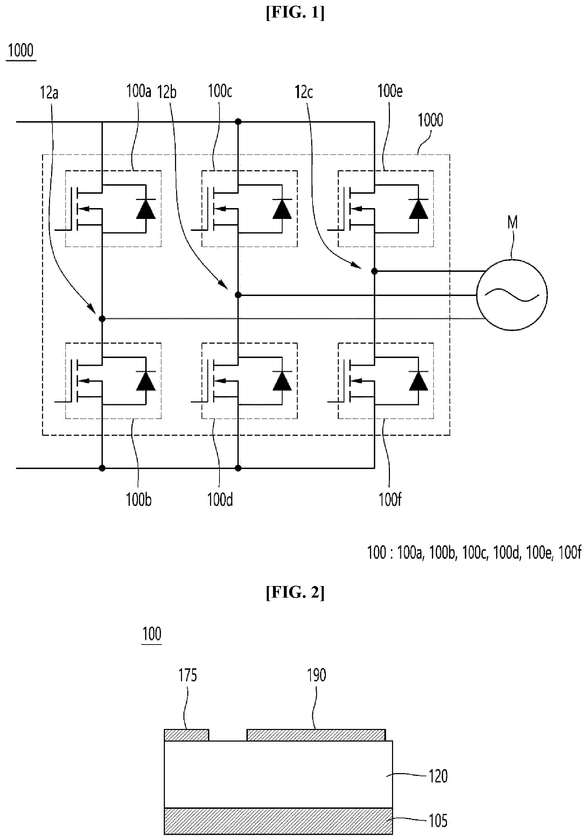

FIG. 1 is an example diagram of a power converter (1000) according to an embodiment.

The power converter (1000) according to the embodiment can receive DC power from a battery or a fuel cell, convert it into AC power, and supply AC power to a predetermined load. For example, the power converter (1000) according to the embodiment can include an inverter, and can receive DC power from a battery, convert it into three-phase AC power, and supply it to a motor (M), and the motor (M) can provide power to an electric vehicle, a fuel cell vehicle, etc.

The power converter (1000) according to the embodiment can include a power semiconductor device (100). The power semiconductor device (100) can be a MOSFET (Metal Oxide Semiconductor Field Effect Transistor), but is not limited thereto, and can include an IGBT (Insulated Gate Bipolar Transistor).

For example, the power converter (1000) may include a plurality of power semiconductor devices (100a, 100b, 100c, 100d, 100e, 100f) and may include a plurality of diodes (not shown). Each of the plurality of diodes may be embedded in the power semiconductor devices (100a, 100b, 100c, 100d, 100e, 100f) in the form of an internal diode, but is not limited thereto, and may be arranged separately.

The embodiment may convert DC power into AC power through on-off control for a plurality of power semiconductor devices (100a to 100f). For example, the power converter (1000) according to the embodiment can supply positive power to the motor (M) by turning on the first power semiconductor device (100a) and turning off the second power semiconductor device (100b) in the first-time section of one cycle, and supply negative power to the motor (M) by turning off the first power semiconductor device (100a) and turning on the second power semiconductor device (100b) in the second-time section of one cycle.

In the embodiment, a group of power semiconductor devices arranged in series on the high-voltage line and the low-voltage line of the input side can be called an arm. For example, the first power semiconductor device (100a) and the second power semiconductor device (100b) may constitute a first arm, the third power semiconductor device (100c) and the fourth power semiconductor device (100d) may constitute a second arm, and the fifth power semiconductor device (100e) and the sixth power semiconductor device (100f) may constitute a third arm.

In the arm, the upper power semiconductor device and the lower power semiconductor device may be controlled not to be turned on at the same time. For example, in the first arm, the first power semiconductor device (100a) and the second power semiconductor device (100b) may not be turned on at the same time but may be turned on and off alternately.

Each power semiconductor device (100a to 100f) may receive high power in an off state. For example, when the first power semiconductor device (100a) is turned on and the second power semiconductor device (100b) is turned off, the input voltage can be applied as it is to the second power semiconductor device (100b). The voltage input to the second power semiconductor device (100b) can be a relatively high voltage, and the withstand voltage of each power semiconductor device (100a to 100f) can be designed to be high so as to withstand this high voltage.

Each power semiconductor device (100a to 100f) can conduct a high current when turned on. The motor (M) is driven by a relatively high current, and this high current can be supplied to the motor (M) through the power semiconductor device that is turned on.

The high voltage applied to each power semiconductor device (100a to 100f) can cause a high switching loss. A high current that conducts the power semiconductor devices (100a to 100f) may cause high conduction loss. In order to release the heat generated by this loss, the power semiconductor devices (100a to 100f) may be packaged into a power semiconductor module including a heat dissipation means.

The power semiconductor device (100) of the embodiment may be a silicon carbide (SiC) power semiconductor device, and may be capable of operating in a high temperature and high voltage environment and may have a high switching speed and a low switching loss.

Meanwhile, the power converter (1000) according to the embodiment may include a plurality of power semiconductor modules.

For example, a plurality of power semiconductor devices (100a to 100f) illustrated in FIG. 1 may be packaged into one power semiconductor module, or the power semiconductor devices constituting each arm may be packaged into one power semiconductor module.

For example, the first power semiconductor device (100a), the second power semiconductor device (100b), the third power semiconductor device (100c), the fourth power semiconductor device (100d), the fifth power semiconductor device (100e), and the sixth power semiconductor device (100f) illustrated in FIG. 1 may be packaged as one power semiconductor module.

In addition, in order to increase the current capacity, there may be additional power semiconductor devices arranged in parallel with each power semiconductor device (100a to 100f). In this case, the number of power semiconductor devices included in the power semiconductor module may be more than six.

The power converter (1000) according to the embodiment may also include a power semiconductor device in the form of a diode in addition to the power semiconductor devices in the form of a transistor (100a to 100f). For example, a first diode (not shown) may be arranged in parallel with a first power semiconductor device (100a), and a second diode (not shown) may be arranged in parallel with a second power semiconductor device (100b). In addition, these diodes may also be packaged together in one power semiconductor module. In addition, the diodes may be arranged in the form of internal diodes in each power semiconductor device.

Next, the power semiconductor devices constituting each arm may be packaged in one power semiconductor module.

For example, the first power semiconductor device (100a) and the second power semiconductor device (100b) constituting the first arm may be packaged as a first power semiconductor module, the third power semiconductor device (100c) and the fourth power semiconductor device (100d) constituting the second arm may be packaged as a second power semiconductor module, and the fifth power semiconductor device (100e) and the sixth power semiconductor device (100f) constituting the third arm may be packaged as a third power semiconductor module.

In addition, in order to increase the current capacity, there may be additional power semiconductor devices arranged in parallel with each power semiconductor device (100a to 100f), in which case the number of power semiconductor devices included in each power semiconductor module may be more than two. In addition to the transistor-type power semiconductor devices (100a to 100f), each arm may also include a diode-type power semiconductor device (not shown), and these diodes may also be packaged together in one power semiconductor module. In addition, the diode may be arranged in the form of an internal diode in each power semiconductor device.

Next, FIG. 2 is a cross-sectional view of one of the power semiconductor devices (100) according to the embodiment.

The power semiconductor device (100) according to the embodiment may include a source electrode (190), a gate electrode (175) arranged on an upper side of a predetermined semiconductor epi layer (120), and a drain electrode (105) arranged on a lower side of the semiconductor epi layer (120).

In the form of a MOSFET, the source electrode (190) or the gate electrode (175) may include an Al series metal, and the drain electrode (105) may include a Ti/Ni/Ag metal including a Ti layer, a Ni layer, and an Ag layer, or NiV/Ag, V(vanadium)/Ni/Ag, etc., but is not limited thereto.

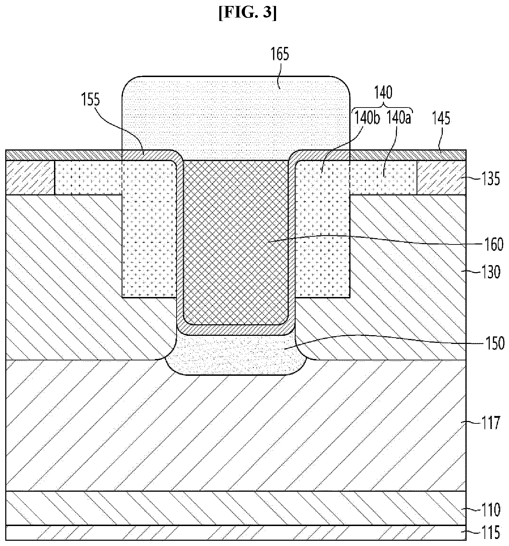

Next, FIG. 3 is a cross-sectional view of a power semiconductor device according to the first embodiment. Referring to FIG. 3, the power semiconductor device according to the first embodiment may include at least one of a substrate (110), a drain electrode (115), an epi layer of a first conductivity type (117), a plurality of plurality of wells of a second conductivity type (130), a doped region of the first conductivity type (140), a source contact layer (145), a gate (160), and/or a gate insulating layer (155). `The epi layer of the first conductivity type' can be referred as 'the epi layer'. In addition, 'the plurality of plurality of wells of the second conductivity type' can be referred as 'the plurality of plurality of wells' or 'wells'. In addition, other elements can be referred while omitting the conductivity type.

In detail, in the first embodiment, the drain electrode (115) may be arranged under the substrate (110). In addition, the epi layer (117) may be disposed on the substrate (110). The epi layer (117) may be an N-type drift region, but is not limited thereto.

In addition, the plurality of wells (130) may be disposed on the epi layer (117). The plurality of wells (130) may include a plurality of wells spaced apart from each other. The gate (160) and the gate insulating layer (155) may be disposed between the plurality of wells (130). The gate insulating layer (155) may be disposed to surround side and bottom surfaces of the gate (160). The gate (160) may be located on an inner side of the gate insulating layer (155). In addition, a JFET region (150) may be arranged under the gate (160) and the gate insulating layer (155) to protect the gate insulating layer (155), but is not limited thereto.

Meanwhile, in the case of a trench MOSFET being studied internally, a problem has been studied in which the gate insulating layer may be damaged due to electric fields being concentrated in a lower edge area of the trench gate. To this end, a separate ion implantation area such as a P-shield process was formed to prevent the electric field concentration, but there was difficulty in a process of forming a separate ion implantation area.

In addition, the trench-structured MOSFET had a problem in that the reliability of the device was reduced because it was difficult to precisely control the channel area and the short circuit characteristics.

To solve the above problem, in the embodiment, the plurality of wells (130) may be formed deeper than the gate (160) and the gate insulating layer (155). In detail, a lower surface of the plurality of wells (130) may be positioned lower than a lower surface of the gate (160) and the gate insulating layer (155). In addition, the plurality of wells (130) may be in contact with the gate insulating layer (155). Therefore, the embodiment has a technical effect of preventing the electric field concentration by arranging the plurality of wells (130) to surround the lower edge area of a trench type gate.

In addition, in the embodiment, a doped region (140), an ion implantation region of the second conductivity type (135), and a source contact layer (145) may be arranged on the plurality of wells (130). Meanwhile, the doped region (140) may be arranged on the side surface of the gate insulating layer (155). The doped region (140) may be arranged to extend along the gate insulating layer (155) to the source contact layer (145).

In addition, the lower surface of the doped region (140) may be positioned higher than the lower surfaces of the gate (160) and the gate insulating layer (155). In addition, the depth of the doped region (140) may be formed shallower than the depth of the gate (160). In addition, a vertical thickness of the doped region (140) may be at least 1/2 of a vertical thickness of the gate (160), but is not limited thereto. According to the embodiment, by forming the channel region so that the vertical depth of the doped region (140) is at least 1/2 of the vertical depth of the gate (160), there is an effect of reliably controlling the electric field compared to a conventional trench type gate structure.

Accordingly, in the embodiment, a channel may be formed between the lower surface of the doped region (140) and the lower surface of the plurality of wells (130). For example, the channel region may be formed in the region of the plurality of wells (130) that contacts the gate insulating layer (155).

Meanwhile, the region formed on the side of the gate (160) in the doped region (140) may be formed through an epitaxial re-growth process rather than an implant process. Accordingly, the embodiment can accurately control the depth of the doped region (140). Since the depth of the doped region (140) can be accurately controlled, the embodiment has a special technical effect of accurately controlling the length of the channel.

In addition, the embodiment has a technical effect of preventing damage that occurs while forming the doping region. For example, the embodiment can prevent damage that may occur during the implant process by forming the second doped region of the first-conductivity type through an epitaxial re-growth process instead of an implant process without a separate P-shield process.

In addition, the embodiment has a technical effect that can prevent electric field concentration in the lower edge region of the trench gate. For example, the embodiment can prevent electric field concentration in the lower edge region of the trench gate by positioning the wells to surround the lower edge region of the trench gate.

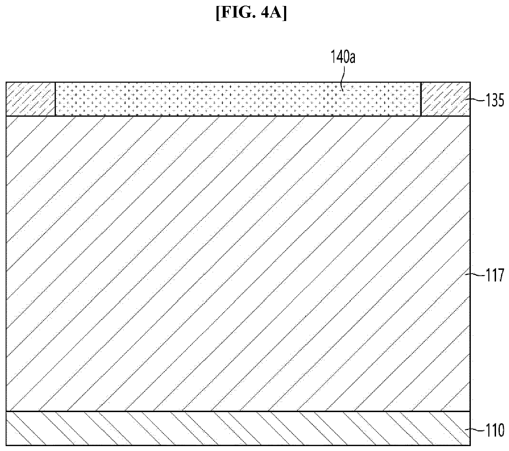

Hereinafter, the technical features of the embodiment will be described in detail while explaining the manufacturing process of the power semiconductor device according to the first embodiment with reference to FIGS. 4A to 4G.

Referring to FIG. 4A, an epi layer of a first conductivity type (117) can be formed on a substrate (110).

The substrate (110) and the epi layer of the first conductivity type (117) may include SiC (Silicon Carbide), but are not limited thereto.

For example, the substrate (110) and the epi layer (117) may include 4H-SiC material, but are not limited thereto. For example, the substrate (110) and the epi layer (117) may include 3C-SiC material or 6H-SiC material.

In addition, the epi layer (117) may include multiple layers having different concentrations and may have a current spreading layer (not shown).

For example, the epi layer (117) may include a first-conductivity buffer layer (not shown) and a first-conductivity drift layer (not shown).

In addition, the first conductivity type may be N-type, and the second conductivity type may be P-type, but is not limited thereto.

In addition, a first doped region of the first conductivity type (140a) and a second conductivity type ion implantation region (135) may be formed on the epi layer (117) through an implant process. The first doped region (140a) may be located between the second conductivity type ion implantation regions (135). A longitudinal direction of the first doped region (140a) may be a horizontal direction.

For example, the first doped region (140a) can function as a source region, and can be formed by ion-implanting an N-type dopant such as nitrogen or phosphorus at a concentration of about 1× 10¹⁹cm⁻³ to about 3 × 10²⁰cm⁻³.

In addition, the ion-implanted region of the second conductivity type (135) can then be brought into contact with a source electrode. In addition, the ion-implanted region (135) can function to maintain a potential of the wells (130), and can function as a body diode.

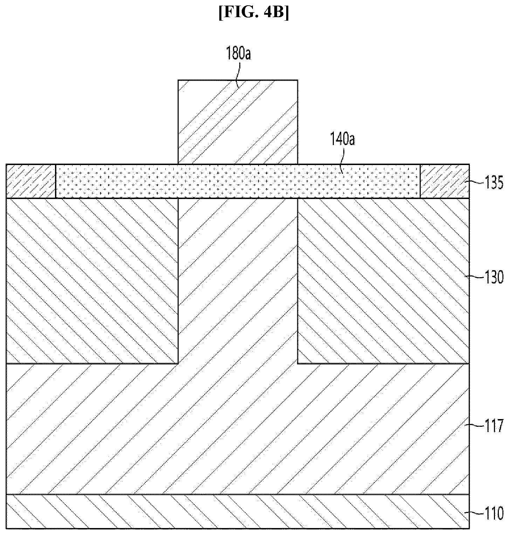

Next, referring to FIG. 4B, after a first mask (180a) is disposed on the first doped region of the first conductivity type (140a), a plurality of wells (130) can be formed through an implant process. The first mask (180a) may be a hard mask such as oxide, but is not limited thereto. The plurality of wells (130) may be ion-implanted with a P-type dopant at a concentration of about 1×10¹⁶ cm⁻³ to about 2×10¹⁹ cm⁻³. For example, aluminum or boron may be implanted, but is not limited thereto. The plurality of wells (130) may include a plurality of regions spaced apart from each other by the first mask (180a) with the epi layer (117) interposed therebetween.

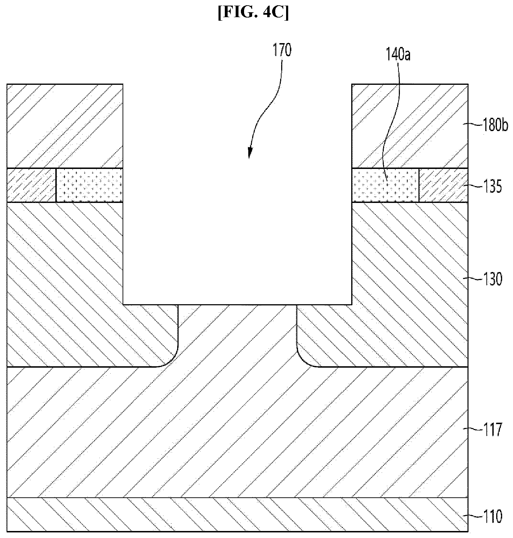

Next, referring to FIG. 4C, after a second mask (180b) is disposed on the plurality of wells (130), a first trench (170) may be formed through etching. The second mask (180a) may be a hard mask such as oxide, but is not limited thereto.

For example, the first doped region of the first conductivity type (140a), the plurality of wells (130), and a part of the epi layer (117) may be removed to form a first trench (170). The depth of the first trench (170) may be shallower than the depth of the plurality of wells (130).

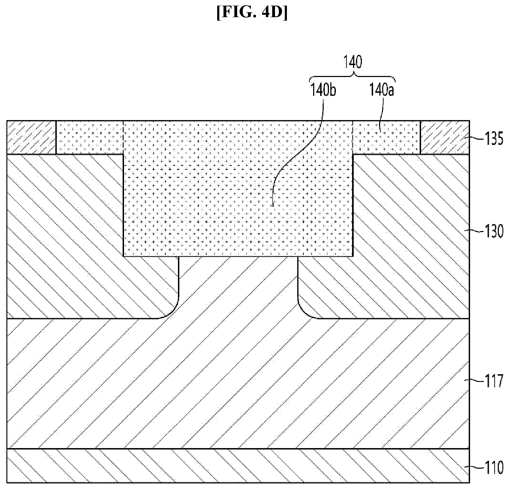

Next, referring to FIG. 4D, a second doped region of the first conductivity type (140b) may be formed in the first trench (170). The second doped region (140b) may be formed through an epitaxial regrowth within the first trench (170). Thereafter, a planarization process may be performed to form the second doped region (140b) and the first doped region of the first conductivity type (140a) to have the same height on the upper surface. The doping concentration of the second doped region (140b) may be substantially the same as the doping concentration of the first doped region (140a), but is not limited thereto.

For example, the second doped region (140b) can be formed through the epitaxial regrowth to include an N-type dopant such as nitrogen or phosphorus at a concentration of about 1 × 10¹⁹cm⁻³ to about 3×10²⁰ cm⁻³, but is not limited thereto.

In the embodiment, since the second doped region (140b) is formed through an epitaxial re-growth process rather than an implant process, the depth of the second doped region (140b) can be controlled.

For a moment, referring to FIG. 3, a channel can be formed between the wells (130) in contact with the gate insulating layer (155), and since the depth of the second doped region (140b) can be controlled, there is a technical effect of precisely controlling the length of the channel.

Meanwhile, when a doped region is formed through an implant process, a damage may accumulate due to high energy. And in the case of silicon carbide (SiC), a high-temperature annealing process of about 1700°C to 1800°C is inevitable to recover the damage, but it is impossible to completely recover even through high-temperature annealing process. On the other hand, since the embodiment forms the second doped region (140b) through the epitaxial regrowth process rather than the implant process, there is a technical effect that can prevent irreparable damage caused by the implant process.

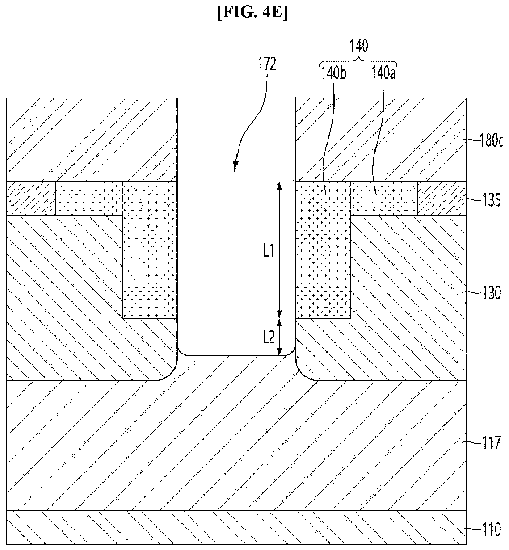

Next, referring back to FIG. 4E, after a third mask (180c) is disposed on the doped region (140), a part of the second doped region (140b) may be etched to form a second trench (172). When the second trench (172) is formed, a part of the epi layer (117) may be removed. The third mask (180c) may be a hard mask such as oxide, but is not limited thereto.

A bottom surface of the second trench (172) may be located higher than a bottom surface of the plurality of wells (130). In addition, the bottom surface of the second trench (172) may be positioned lower than the bottom surface of the second doped region (140b).

The third mask (180c) may be an inverted form of the first mask (180a) used previously. Accordingly, a side surface of the third mask (180c) may be aligned with one side surface of the plurality of wells (130) from top to bottom, but is not limited thereto. Accordingly, when the second trench (172) is formed, the plurality of wells (130) may be removed to expose a portion of the side surface, but is not limited thereto.

In the embodiment, a first length (L1) of the second doped region (140b) exposed by the second trench (172) may be longer than a second length (L2) of the plurality of wells (130) exposed by the second trench (172). For example, the second length (L2) of the plurality of wells (130) exposed by the second trench (172) may be about 40% to 70% of a total depth of the second trench (172), but is not limited thereto.

The exposed region at the second length (L2) of the plurality of wells (130) exposed by the second trench (172) may function as a channel region.

According to the embodiment, the plurality of wells (130) may be arranged to surround the lower edge region of the trench gate, thereby providing a technical effect of preventing electric field concentration in the lower edge region of the trench gate.

Accordingly, the embodiment can form the plurality of wells (130) to surround the lower edge region of the trench gate without a separate P-shield process. So, the embodiment can eliminate the need for a high-energy ion implantation process, and can provide a technical effect of preventing damage to the device and improving the reliability of the device.

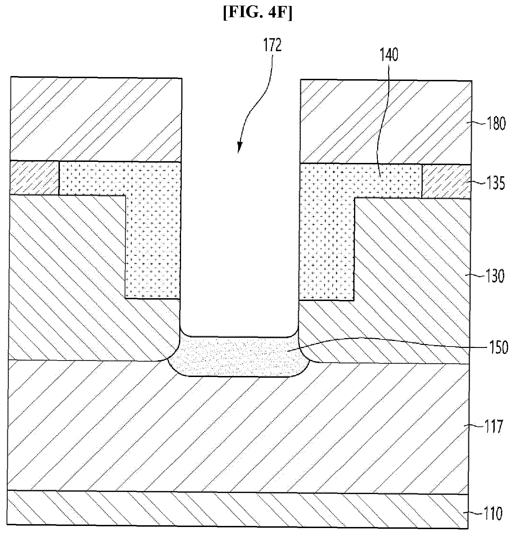

Next, referring to FIG. 4F, a JFET region (150) may be formed under the second trench (172) through an implant process, but is not limited thereto. The JFET region (150) may be located between a plurality of wells (130). In addition, the lower surface of the JFET region (150) may be located lower than the lower surface of the plurality of wells (130).

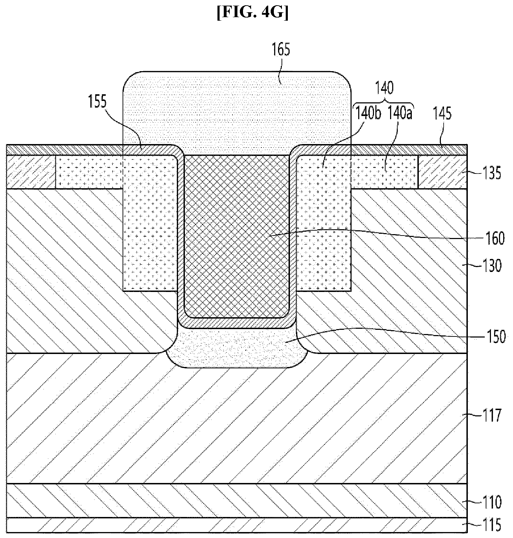

Next, referring to FIG. 4G, after forming a gate insulating layer (155) on the second trench, a gate (160) may be formed inside the gate insulating layer (155). The gate insulating layer (155) may be a thermal oxide film or a deposition oxide film, but is not limited thereto. In addition, the lower surface of the gate (160) and the gate insulating layer (155) may be located lower than the lower surface of the second doped region (140b). In addition, the lower surface of the gate (160) and the gate insulating layer (155) may be positioned higher than the lower surface of the plurality of wells (130). In addition, an insulating layer (165) may be formed on the gate (160).

In addition, a source contact layer (145) may be formed on the ion implantation region of the second conductivity type (135), and a source electrode (not shown) may be formed on the source contact layer (145) in a subsequent process.

Next, an insulating layer (165) may be formed on the gate (160) and the gate insulating layer (155). The insulating layer (165) may be formed of an oxide film or a nitride film, but is not limited thereto.

In addition, a source electrode (not shown) may be formed on the source contact layer (145). The source electrode may be formed to cover the insulating layer (165). The above source electrode may be formed of Al, etc., but is not limited thereto. In addition, the source electrode may further include a barrier metal layer.

In addition, a drain electrode (115) may be formed on a lower side of the substrate (110). The drain electrode (115) may include Ti/Ni/Ag metal including a Ti layer, a Ni layer, and an Ag layer, or NiV/Ag, V(vanadium)/Ni/Ag, etc., but is not limited thereto.

Accordingly, in the embodiment, current may flow through the drain electrode (115), the substrate (110), the epi layer (117), the plurality of wells (130), the doped region (140), and the source electrode (not shown).

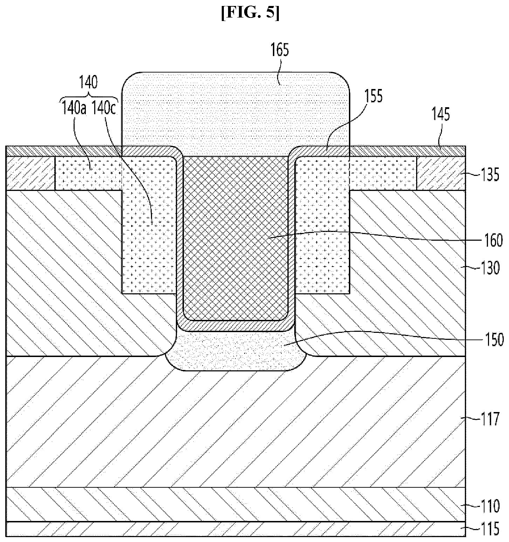

Next, FIG. 5 is a cross-sectional view of a power semiconductor device according to the second embodiment. The second embodiment may adopt the technical features of the first embodiment. For example, the second embodiment has a technical effect of preventing electric field concentration in the bottom edge region of the gate as the plurality of wells (130) surrounds the gate (160) and the bottom edge region of the gate insulating layer (155).

Next, referring to FIG. 5, in the second embodiment, the doped region (140) may include a first doped region of the first conductivity type (140a) and a third doped region of the first conductivity type (140c).

At this time, the doping concentration of the first doped region (140a) may be different from the doping concentration of the third doped region (140c). In detail, the doping concentration of the third doped region (140c) may be lower than the doping concentration of the first doped region (140a). The first doped region (140a) may be arranged under the source contact layer (145). In addition, one side of the third doped region (140c) may vertically overlap one side of the insulating layer (165). The third doped region (140c) may not vertically overlap the source contact layer (145).

In the second embodiment, the third doped region (140c) may be formed through epitaxial regrowth in the first trench (170) (see FIG. 4D). Thereafter, a planarization process may be performed to form the same height of the upper surface of the third doped region (140c) and the first doped region (140a).

At this time, the doping concentration of the third doped region (140c) may be lower than the doping concentration of the first doped region (140a).

For example, the first doped region (140a) may be formed by ion implanting an N-type dopant, such as nitrogen or phosphorus, at a concentration of about 1 × 10¹⁹cm⁻³ to about 3×10²⁰cm⁻³.

On the other hand, the third doped region (140c) may be formed through epitaxial re-growth so as to include an N-type dopant, such as nitrogen or phosphorus, at a concentration of about 1×10¹⁷cm⁻³ to about 3 × 10¹⁹cm⁻³, but is not limited thereto.

According to the second embodiment, the third doped region (140c) is arranged on the side of the gate (160) and is formed to have a lower doping concentration than the first doped region (140a) that contacts the source contact layer (145), so that the saturation current can be reduced.

Specifically, in the second embodiment, the saturation current can be reduced as the current passes through the doped region (140) whose doping concentration changes in the vertical direction from the trench gate side.

In detail, according to the second embodiment, the sheet resistance in the third doped region (140c) can be controlled to relatively increase since the third doped region (140c) is formed to have the lower doping concentration than the first doped region (140a) such that an on-resistance (Ron) in the third doped region (140c) can be relatively increased and a saturation current can be decreased.

Therefore, the second embodiment has a technical effect of improving the reliability during high-speed switching by increasing the SCWT (Short Circuit Withstand Time) as the saturation current decreases.

The power semiconductor device according to the embodiment has a technical effect of preventing the electric field concentration in the lower edge area of the trench gate.

For example, the embodiment can prevent the electric field concentration in the lower edge region of the trench gate by arranging the wells to surround the lower edge region of the trench gate.

In addition, the embodiment has a technical effect capable of controlling the length of the channel. For example, the embodiment forms the second doped region through an epitaxial re-growth process rather than an implant process, so that the doping concentration can be uniformly controlled compared to the ion implantation process. And accordingly, the depth of the doped region can be precisely controlled, so that the length of the channel can be precisely controlled.

For example, since the doping concentration deviation in the second doped region is uniformly controlled to within about 5 to 10%, there is a special technical effect capable of precisely controlling the length of the channel.

In addition, the embodiment has a technical effect capable of preventing damage occurring while forming the doped region. For example, the embodiment can prevent damage that may occur during the implant process by forming the second doped region through an epitaxial re-growth process instead of an implant process without a separate P-shield process.

In addition, the embodiment has a technical effect that can improve the reliability of the device during high-speed switching.

For example, the embodiment can improve the reliability of the device during high-speed switching by forming the doping concentration of the second doped region arranged on the trench gate side lower than the doping concentration of the first doped region, thereby reducing the saturation current and increasing the SCWT (Short Circuit Withstand Time).

Although the above has been described with reference to the embodiments of the present invention, it will be readily understood by those skilled in the art that various modifications and changes can be made to the present invention without departing from the spirit and scope of the present invention described in the following patent claims.

**[Reference signs]**

| | | | |
|---|---|---|---|
| 110: | substrate | 115: | drain electrode |
| 117: | epi layer of the first conductivity type | 130: | wells of the second conductivity type |
| 135: | ion implantation region of the second conductivity type | | |
| 140: | doped region of the first conductivity type | | |
| 140a: | first doped region of the first conductivity type | | |
| 140b: | second doped region of the first conductivity type | | |
| 145: | source contact layer | 150: | JFET region |
| 155: | gate insulating layer | 160: | gate |
| 165: | insulating layer | 170: | first trench |
| 172: | second trench | 180a, 180b, 180c: | first, second, third Masks |

## Claims

1. A power semiconductor device comprising:
a substrate;
an epi layer of a first conductivity type disposed on the substrate;
a plurality of wells of a second conductivity type disposed spaced apart from each other on the epi layer;
a gate disposed between the wells and a gate insulating layer disposed to surround at least a portion of the gate; and
a doped region of the first conductivity type disposed on a side of the gate insulating layer,
wherein the doped region comprises:
a first doped region of the first conductivity type having a first horizontal width; and
a second doped region of the first conductivity type having a second horizontal width smaller than the first horizontal width, disposed below the first doped region.

2. The power semiconductor device according to claim 1, wherein a lower surface of the second doped region is positioned higher than a lower surface of the gate.

3. The power semiconductor device according to any one of claims 1 or 2, wherein a lower edge region of the gate insulating layer is in contact with the wells.

4. The power semiconductor device according to any one of claims 1 to 3, wherein bottom surfaces of the wells is positioned lower than a bottom surface of the gate insulating layer.

5. The power semiconductor device according to any one of claims 1 to 4, wherein the doped region and the epi layer are spaced apart from each other, and
the wells are positioned between the doped region and the epi layer.

6. The power semiconductor device according to any one of claims 1 to 5, wherein a doping concentration of the second doped region is substantially the same as a doping concentration of the first doped region.

7. The power semiconductor device according to any one of claims 1 to 6, wherein a doping concentration of the second doped region is lower than the doping concentration of the first doped region.

8. The power semiconductor device according to any one of claims 1 to 7, wherein the second doped region is formed by an epitaxial re-growth process.

9. The power semiconductor device according to any one of claims 1 to 8, wherein the second doped region is configured not to vertically overlap with a source contact layer.

10. The power semiconductor device according to any one of claims 1 to 9, wherein a vertical thickness of the second doped region is at least 1/2 of a vertical thickness of the gate.

11. The power semiconductor device according to any one of claims 1 to 10, further including a JFET region arranged on a lower surface of the gate insulating layer, and
wherein the JFET region is in contact with the wells.

12. The power semiconductor device according to any one of claims 1 to 11, wherein the second doped region is arranged on an inner side of the first doped region.

13. The power semiconductor device according to any one of claims 1 to 12, wherein an upper surface of the second doped region is positioned at the same height as an upper surface of the first doped region.

14. The power semiconductor device according to any one of claims 1 to 13, wherein a thickness of the second doped region is greater than a vertical thickness of the first doped region.

15. A power converter including the power semiconductor device according to any one of claims 1 to 14.
